# EUROPEAN PATENT APPLICATION

(11) **EP 4 378 598 A1**
(43) Date of publication of application: **05.06.2024**
(21) Application number: 21951627.5
(22) Date of filing: 11.11.2021
(51) Int. Cl.: B08B 7/00, B08B 5/00, B08B 9/08, H01L 21/3065

(54) **PLASMA TREATMENT METHOD**

(30) Priority: 30.07.2021 CN 202110873631
(71) Applicant: Jiangsu Leuven Instrumments Co., Ltd., Xuzhou, Jiangsu 221300 (CN)
(72) Inventor: HAN, Dajian, Xuzhou, Jiangsu 221300 (CN); LI, Na, Xuzhou, Jiangsu 221300 (CN); PENG, Taiyan, Xuzhou, Jiangsu 221300 (CN); CHE, Dongchen, Xuzhou, Jiangsu 221300 (CN); XU, Kaidong, Xuzhou, Jiangsu 221300 (CN)
(74) Representative: Eisenführ Speiser
(86) International application number: PCT/CN2021/130029
(87) International publication number: WO 2023/005055

(57) **Abstract**

A plasma treatment method, which is applied to a plasma treatment apparatus, wherein the plasma treatment apparatus comprises an ion source cavity (10), and sediment is present in the ion source cavity (10). The plasma treatment method comprises: introducing cleaning gas into an ion source cavity (10) for ionization to generate a first plasma, so that the first plasma reacts with sediment in the ion source cavity (10) to generate a gas compound, which is then discharged, thereby achieving the aim of cleaning the sediment in the ion source cavity (10).

## Description

This application claims priority to Chinese Patent Application No. 202110873631.4, titled "METHOD FOR PROCESSING USING PLASMA ", filed on July 30, 2021 with the China National Intellectual Property Administration, which is incorporated herein by reference in its entirety.

### FIELD

The present disclosure relates to the technical field of semiconductor processing, and in particular, to a method for processing using plasma.

### BACKGROUND

Miniaturization and densification of integrated circuits, integrated optical circuit, and other optoelectronic devices are intensifying requirements on semiconductor etching. Conventional wet etching techniques result in severe undercutting due to its isotropic characteristics and thus a rough edge of an obtained pattern, and therefore it is difficult to obtain a linewidth below 3µm through these techniques. Accordingly, dry etching techniques have emerged and become a major trend for future fine-pattern etching, because dry etching is capable to transfer a pattern on to a material accurately due to anisotropic characteristics and processing parameters which can be flexibly controlled. Ion beam etching is an important type of dry etching, and has been widely applied. During the ion beam etching, plasma is generated in an ion source chamber through ionizing a gas, and is accelerated by accelerating electrodes to bombard a to-be-etched material. Atoms in the to-be-etched material are sputtered under the bombardment, and are then pumped out by a vacuum pump. Thereby, the etching is implemented.

Generally, the gas utilized the ion beam etching are an inert gas, such as Ar, Kr, and Xe. The inert gas has a large molecular mass, which introduces a strong collision after the acceleration, and does not react with the to-be-etched material substantially, which leads to an excellent anisotropic effect of the ion beam etching. The ion beam etching is pure physical etching, and has a slow etching rate. A reactive gas capable of reacting with the to-be-etched material may be introduced to accelerate the etching and facilitate adjustment on etching morphology. In such case, the etching is called reactive ion beam etching.

The reactive ion beam etching is apt to form deposits in the ion source chamber due to ionization of the reactive gas. Thereby, an inner wall of the ion source chamber is stained, which in turn affects the ionization of the reactive gas. How to clean up the deposits in the ion source chamber has become an urgent technical problem to be solved by those skilled in the art.

### SUMMARY

A method for processing using plasma is provided according to an embodiment of the present disclosure, so as to address at least the foregoing technical issues. The ion source chamber can be cleaned to remove the deposits.

Following Technical solutions are provided to according to embodiments of the present disclosure.

A method for processing using plasma is provided according to embodiments of the present disclosure. The method is applicable to a plasma processing device which comprises an ion source chamber, where deposits are located in the ion source chamber. The method comprises: injecting a cleaning gas into the ion source chamber and ionizing the cleaning gas in the ion source chamber to generate first plasma; and ejecting a gaseous compound, which is generated through reaction between the first plasma and the deposits in the ion source chamber, from the ion source chamber.

In one embodiment, the plasma processing device further comprises an etching chamber. The method further comprises: injecting an etching gas into the ion source chamber and ionizing the etching gas in the ion source chamber to generate second plasma, where the generated second plasma enters the etching chamber to etch a to-be-etched object.

In one embodiment, a process of injecting the cleaning gas into the ion source chamber and ionizing the cleaning gas in the ion source chamber is performed after a process of injecting the etching gas into the ion source chamber and ionizing the etching gas in the ion source chamber.

In one embodiment, a process of injecting the cleaning gas into the ion source chamber and ionizing the cleaning gas in the ion source chamber is performed during a process of injecting the etching gas into the ion source chamber and ionizing the etching gas in the ion source chamber.

In one embodiment, the process of injecting the cleaning gas into the ion source chamber and ionizing the cleaning gas in the ion source chamber is performed simultaneously with the process of injecting the etching gas into the ion source chamber and ionizing the etching gas in the ion source chamber.

In one embodiment, the process of injecting the cleaning gas into the ion source chamber and ionizing the cleaning gas in the ion source chamber and the process of injecting the etching gas into the ion source chamber and ionizing the etching gas are performed alternately.

In one embodiment, the process of injecting the cleaning gas into the ion source chamber and ionizing the cleaning gas in the ion source chamber is performed intermittently, while injecting the etching gas into the ion source chamber and ionizing the etching gas in the ion source chamber.

In one embodiment, the plasma processing device further comprises a baffle disposed between the ion source chamber and the etching chamber. The method further comprises: disposing the baffle in a first state, when injecting the etching gas into the ion source chamber and ionizing the etching gas in the ion source chamber, where the first state of the baffle enables an inner space of the ion source chamber and an inner space of the etching chamber to connect; and disposing the baffle in a second state when stopping injecting the etching gas into the ion source chamber or when completing etching the to-be-etched object, where the second state of the baffle disconnects the inner space of the ion source chamber and the inner space of the etching chamber are blocked by the baffle.

In one embodiment, the etching gas is a fluorine-based gas.

In one embodiment, the cleaning gas is oxygen.

The above technical solutions are advantageous over the conventional technology in at least following aspects.

The method for processing using plasma according to embodiments of the present disclosure is applicable to the plasma processing device comprising the ion source chamber, where the deposits are located in the ion source chamber. The method comprises: injecting the cleaning gas into the ion source chamber and ionizing the cleaning gas in the ion source chamber to generate the first plasma; and ejecting the gaseous compound, generated through reaction between the first plasma and the deposits in the ion source chamber, from the ion source chamber. Thereby, the deposits are removed from the ion source chamber. The method is more efficient, less time-consuming, and less costly than opening the ion source chamber manually for cleaning in conventional technology, and a yield can be increased.

### BRIEF DESCRIPTION OF THE DRAWINGS

Hereinafter drawings to be applied in embodiments of the present disclosure or in conventional technology are briefly described, in order to clarify illustration of technical solutions according to embodiments of the present disclosure or in conventional technology. Apparently, the drawings in the following descriptions are only some embodiments of the present disclosure, and other drawings may be obtained by those skilled in the art based on the provided drawings without exerting creative efforts.
Figure 1 is a schematic structural diagram of a plasma processing device.
Figure 2 is a schematic flowchart of a method for processing using plasma according to an embodiment of the present disclosure.
Figure 3 shows a schematic diagram of performing a process of injecting an etching gas into the ion source chamber and ionizing the etching gas in the ion source chamber simultaneously with a process of injecting a cleaning gas into the ion source chamber and ionizing the cleaning gas in the ion source chamber according to an embodiment of the present disclosure.
Figure 4 is a schematic flowchart of a method for processing using plasma according to another embodiment of the present disclosure.
Figure 5 shows a schematic diagram of performing a process of injecting an etching gas into the ion source chamber and ionizing the etching gas in the ion source chamber simultaneously with a process of injecting a cleaning gas into the ion source chamber and ionizing the cleaning gas in the ion source chamber according to another embodiment of the present disclosure.
Figure 6 is a schematic flowchart of a method for processing using plasma according to another embodiment of the present disclosure.
Figure 7 is a schematic flowchart of a method for processing using plasma according to another embodiment of the present disclosure.

### DETAILED DESCRIPTION OF EMBODIMENTS

Hereinafter a basic structure and operation of a plasma processing device are illustrated first, so as to facilitate understanding of a method for processing using plasma according to embodiments of the present disclosure.

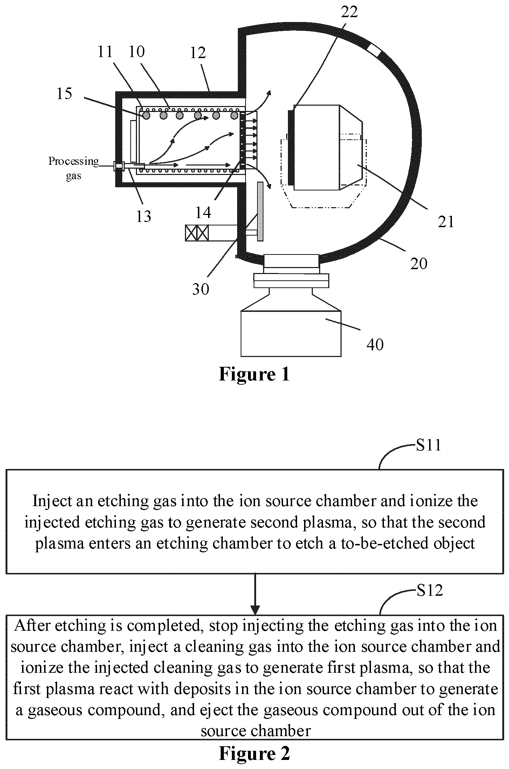

Figure 1 shows a schematic structural diagram of a plasma processing device, which may specifically be a device for reactive ion beam etching. As shown Figure 1, the plasma processing device comprises an ion source chamber 10, an etching chamber 20, a baffle 30, and a vacuum pump 40.

Windings 11 wind along a sidewall of the ion source chamber 10, for example, disposed outside the ion source chamber 10. A housing 12 configured to protecting the ion source chamber 10 is also disposed outside the ion source chamber 10. During operation, a processing gas is injected into the ion source chamber 10 via an inlet 13 of the ion source chamber 10, and ionized in an electromagnetic field induced by the powered windings 11 to generate plasma. The plasma is accelerated by an accelerating grid 14 in the ion source chamber 10 and thus ejected out of the ion source chamber 10.

A stage 21 configured to support a to-be-etched object 22 is disposed in the etching chamber 20. When processing starts, the stage 21 carrying the to-be-etched object 22 may rotate from an initial position to a processing position. When the processing completes, the stage 21 carrying the to-be-etched object 22 rotates from the processing position to the initial position.

The baffle 30 is disposed at a portion connecting an inner space of the ion source chamber 10 and an inner space of the etching chamber 20. When the processing starts, the baffle 30 may fall to connect the inner space of the ion source chamber 10 and the inner space of the etching chamber 20. Thereby, the to-be-etched object 22 is exposed to the ion beam emitted from the ion source chamber 10 for etching. When the processing completes, the baffle 30 may rise to disconnect the inner space of the ion source chamber 10 and the inner space of the etching chamber 20. Thereby, the to-be-etched object 22 is protected from over-etching.

A vacuum pump 40 is further disposed at a bottom of the etching chamber 10. The vacuum pump is configured to provide a high degree of vacuum for the etching process and remove by-products generated during the etching process.

As mentioned in the background, deposits tend to form in the ion source chamber 10. How to clean the ion source chamber to remove the deposits has become an urgent technical problem to be solved by those skilled in the art.

It is discovered that a fluorine-based gas, such as CF₄ or CHF₃, usually serves a reaction gas during reactive ion beam etching, especially that on a grating material for fabricating, for example, blazed gratings and tilted gratings, since the grating material are generally silicon or quartz. The fluorine-based gas is apt to form deposits 15, as indicated in Figure 1, when being ionized in the ion source chamber due to its elements such as C and H. Thereby, an inner wall of the ion source chamber is stained, which affects ionization of the reactive gas in the ion source chamber and thus hinders repetition of the reactive ion beam etching.

In conventional technology, the ion source chamber is opened manually each time the ion source chamber has been used for a period, so as to clean its internal surface. Such solution is not only time-consuming, which affects a yield, but also requires labor-consuming, which increases a cost.

On at least such basis, a method for processing using plasma is provided according to embodiments of the present disclosure. The method is applicable to a plasma processing device comprising an ion source chamber, where deposits are located in the ion source chamber. The method comprises: injecting a cleaning gas into the ion source chamber and ionizing the cleaning gas in the ion source chamber to generate first plasma; and ejecting a gaseous compound, generated through reaction between the first plasma and the deposits in the ion source chamber, from the ion source chamber. Thereby, the deposits are removed from the ion source chamber. The method is more efficient, less time-consuming, and less costly than opening the ion source chamber manually for cleaning in conventional technology, and a yield can be increased.

Hereinafter technical solutions in embodiments of the present disclosure are described clearly and completely in conjunction with the drawings in embodiments of the present closure. Apparently, the described embodiments are only some rather than all of the embodiments of the present disclosure. Any other embodiments obtained based on the embodiments of the present disclosure by those skilled in the art without any creative effort fall within the scope of protection of the present disclosure.

Various specific details are set forth in the following description for full understanding of the present disclosure. The present disclosure may be implemented as other embodiments which are different from those described herein. Those skilled in the art can make deductions without deviating from a concept of the present disclosure. Therefore, the present disclosure is not limited to specific embodiments disclosed as follows.

Moreover, details of the present disclosure are illustrated in conjunction with schematic diagrams. In order to facilitate illustration, when describing embodiments of the present disclosure in detail, a cross-sectional diagram of a device structure may not be enlarged to scale among all portions. The schematic diagrams are merely exemplary and shall not be construed as limitations to a protection scope of the present disclosure. In addition, three-dimensional dimensions, e.g., a length, a width, and a depth, shall be configured in practice.

A method for processing using plasma is provided according to an embodiment of the present disclosure. The method is applicable to a plasma processing device as shown in Figure 1. The plasma processing device comprises an ion source chamber 10, and there are the deposits 15 in the ion source chamber 10. The method comprises following steps.

A cleaning gas is injected into and ionized in the ion source chamber 10 to generate first plasma. A gaseous compound generated through reaction between the first plasma and the deposits 15 in the ion source chamber 10 is ejected from the ion source chamber 10.

A type of the cleaning gas is not limited herein. Specifically, the cleaning gas may be selected according to a type of the deposits in the ion source chamber, so that the first plasma generated through ionizing the injected cleaning gas can react with the deposits in the ion source chamber to generate the gaseous compound which can be ejected.

The plasma processing device to which the method is applicable includes, but is not limited to, a device for reactive ion beam etching. The plasma processing device may alternatively be other devices using plasma for processing, such as a device for ion beam etching. Specific device may depend on an actual situation.

Thereby, with the method for processing using plasma according to embodiments of the present disclosure, the cleaning gas is injected into the ion source chamber and thus ionized in the ion source chamber to generate the first plasma with which the deposits reacts, and thereby the gaseous compound is generated in the ion source chamber and then ejected from the ion source chamber. Thereby, the deposits are removed from the ion source chamber, and the ion source chamber is cleaned. The method is more efficient, less time-consuming, and less costly than opening the ion source chamber manually for cleaning in conventional technology, and a yield can be increased.

Reference is made to Figure 1. In an embodiment on a basis of the foregoing embodiment(s), the plasma processing device further comprises an etching chamber 20, and the method further comprises a following step.

An etching gas is injected into and ionized in the ion source chamber 10 to generate second plasma, such that generated second plasma enters the etching chamber 20 to etch a to-be-etched object 22.

The deposits 15 in the ion source chamber 10 may be generated when the etching gas is ionized in the ion source chamber, which is not limited herein. In other embodiments, the deposits in the ion source chamber may be generated due to another reason, which may depend on an actual situation.

In one embodiment, the etching gas is a fluorine-based gas, such as CHF₃, CF₄, and C₄F₈. The fluorine-based gas comprises elements such as C and H, and hence is apt to form deposits when being ionized in the ion source chamber.

In one embodiment, the cleaning gas is oxygen. Thereby, the deposits generated when ionizing the fluorine-based gas in the ion source chamber can be removed. Oxygen ions are generated when ionizing the oxygen in the ion source chamber, and are liable to react with elements such as C and H in the deposits, so as to generate the gaseous compound, such as CO₂, CO, and H₂O, which can be ejected. Hence, the inner wall of the ion source chamber can be cleaned. The cleaning gas may alternatively be another gas capable of reacting with the elements, such as C and H in the deposits, generated when ionizing the fluorine-based gas and thereby forming the gas compound. The cleaning gas is not limited herein and may depend on an actual situation.

The to-be-etched object 22 may be a wafer, which is not limited herein and may depend on an actual situation.

Thereby, injecting the etching gas into the ion source chamber and ionizing the injected etching gas is a process of etching the to-be-etched object, and injecting the cleaning gas into the ion source chamber and ionizing the injected cleaning gas is a process of removing the deposits in the ion source chamber. With respect to the etching, i.e., a process of injecting the etching gas into the ion source chamber and ionizing the injected etching gas, there may be various timing for performing the removal of the deposits in the ion source chamber, i.e., a process of injecting the cleaning gas into the ion source chamber and ionizing the cleaning gas. Hereinafter the timing is illustrated in several embodiments.

In one embodiment, the process of injecting the cleaning gas into the ion source chamber and ionizing the injected cleaning gas is performed after etching the to-be-etched object, i.e., after the process of injecting the etching gas into the ion source chamber and ionizing the injected etching gas.

Reference is made to Figure 2. In an embodiment, the above sequence is implemented through steps S 11 and S12.

In step S11, the etching gas is injected into and ionized in the ion source chamber to generate the second plasma, so that the second plasma enters the etching chamber to etch the to-be-etched object.

In step S12, after etching is completed, the etching gas is stopped from being injected into the ion source chamber while the cleaning gas is injected into and ionized in the ion source chamber to generate the first plasma, so that the first plasma react with the deposits in the ion source chamber to generate the gaseous compound, and the gaseous compound is ejected out of the ion source chamber.

That is, a manner of cleaning is injecting the cleaning gas into the ion source chamber after the etching is completed. Thereby, the deposits are removed from the ion source chamber, and are prevented from affecting a next round of etching.

The deposits in the ion source chamber may be generated due to ionization of the etching gas, and hence would accumulate in the ion source chamber along with the ionization. When the etching is performed for long time, the ionization of the etching gas in the ion source chamber would be affected in such etching. In a case that the cleaning gas is injected into the ion source chamber after the etching, it may be difficult to clean the ion source chamber due to a large amount of the accumulated deposits. Therefore, in another embodiment, the process of injecting the cleaning gas into the ion source chamber and ionizing the injected cleaning gas is performed during etching the to-be-etched object, i.e., during the process of injecting the etching gas into the ion source chamber and ionizing the injected etching gas. Hence, the deposits generated during the etching can be timely removed, which reduces an impact of the deposits on the ionization of the etching gas.

During the process of injecting the etching gas into the ion source chamber and ionizing the injected etching gas, there are various timing for performing the process of injecting the cleaning gas into the ion source chamber and ionizing the injected cleaning gas. Hereinafter the timing is illustrated in several embodiments.

In one embodiment, the above sequence is implemented through performing the process of injecting the cleaning gas into the ion source chamber and ionizing the injected cleaning gas simultaneously with the process of injecting the etching gas into the ion source chamber and ionizing the injected etching gas.

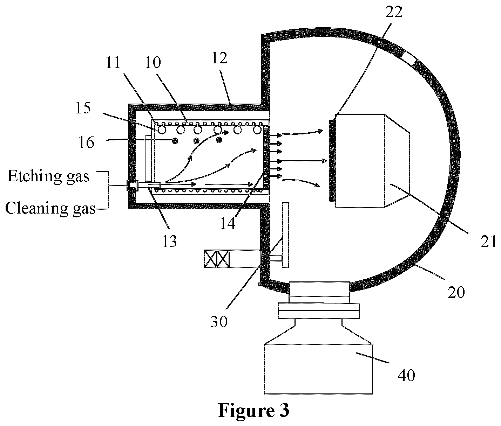

Reference is made to Figure 3. In one embodiment, the etching gas and the cleaning gas are simultaneously injected into and ionized in the ion source chamber 10. The etching gas is ionized to generate the second plasma, and the cleaning gas is ionized to generate the first plasma 16. That is, plasma in the ion source chamber 10 is mixed plasma of the first plasma and the second plasma. A portion of the mixed plasma enters the etching chamber 20 to etch the to-be-etched object 22, while another portion of the mixed plasma remains in the ion source chamber 10. The first plasma 16 in the other portion of the mixed plasma in the ion source chamber 10 is capable to react with the deposits 15 in the ion source chamber, so as to generate the gaseous compound for ejection. Thereby, the deposits 15 can be removed from the ion source chamber 10.

That is, in this embodiment, etching and cleaning the inner wall of the ion source chamber are performed synchronously, which ensures a constant clean inner wall of the ion source chamber. It is not necessary to cleaning the inner wall of the ion source chamber after the etching, which reduces time consumption of the entire process.

When the etching gas and the cleaning gas are simultaneously injected into and ionized in the ion source chamber, the first plasma generated due to ionization of the cleaning gas may also enter the etching chamber and thus etch the to-be-etched object, which may improve an effect of the etching. For example, straightness of the etching is better, and an edge of a patter is cleaner. In such case, an etching mask may be consumed faster, and such issue can be easily addressed through adjusting the masks in practice. That is, the first plasma generated through ionization of the cleaning gas in the ion source chamber can hardly affect an effect of etching the to-be-etched object.

In another embodiment, performing the process of injecting the cleaning gas into the ion source chamber and ionizing the injected cleaning gas during the process of injecting the etching gas into the ion source chamber and ionizing the injected etching gas is implemented through as follows.

The process of injecting the cleaning gas into the ion source chamber and ionizing the injected cleaning gas and the process of injecting the etching gas into the ion source chamber and ionizing the injected etching gas are performed alternately.

In one embodiment, the above two processes alternate in cycles, in each of which the etching gas is first injected into and ionized in the ion source chamber, then the cleaning gas is injected into and ionized in the ion source chamber. In another embodiment, the above two processes alternate in cycles, in each of which the cleaning gas is first injected into and ionized in the ion source chamber, then the etching gas is injected into and ionized in the ion source chamber.

Similarly, a last process of the above alternation may be that the etching gas is injected into and ionized in the ion source chamber, or that the cleaning gas is injected into and ionized in the ion source chamber. The last process is not limited herein and may depend on an actual situation.

Time for injecting the etching gas into the ion source chamber and ionizing the injected etching gas, time for injecting the cleaning gas into the ion source chamber and ionizing the injected cleaning gas, and an interval between the two are not limited herein and may depend on an actual situation.

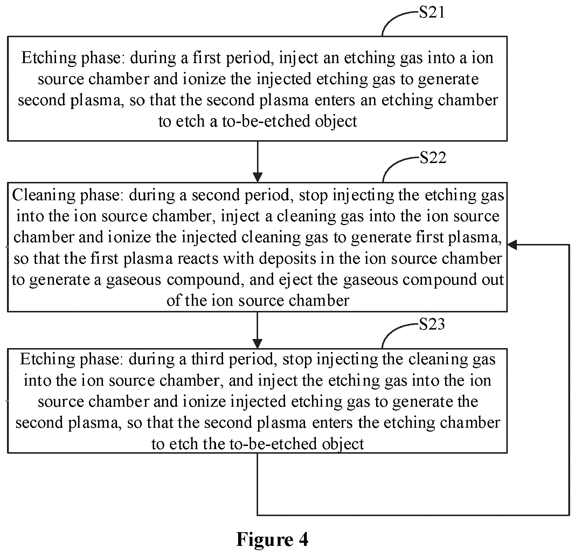

Hereinafter it is taken as an example for illustrating the above alternation that each cycle comprises first injecting the etching gas into the ion source chamber and ionizing the injected etching gas and then injecting the cleaning gas into the ion source chamber and ionizing the injected cleaning gas. Reference is made to Figure 4, in which the method for processing using plasma comprises following steps S21 to S23.

In step S21, during a first period, the etching gas is injected into and ionized in the ion source chamber to generate the second plasma, so that the second plasma enters the etching chamber to etch the to-be-etched object. That is, an etching phase is performed, and the etching phase is called a first etching phase.

In step S22, then during a second period, the etching gas is stopped from being injected into the ion source chamber, and instead the cleaning gas is injected into and ionized in the ion source chamber to generate the first plasma, so that the first plasma reacts with the deposits in the ion source chamber to generate the gaseous compound which is ejected out of the ion source chamber. That is, a cleaning phase is performed, and the cleaning phase is called a first cleaning phase.

In step S23, then during a third period, the cleaning gas is stopped from being injected into the ion source chamber, and instead the etching gas is injected into and ionized in the ion source chamber to generate the second plasma, so that the second plasma enters the etching chamber to etch the to-be-etched object. That is, another etching phase is performed, and such etching phase is called a second etching phase.

After the second etching process phase is completed, the process returns to the step S22 and then the step S23, and hence a second cleaning phase and a third etching phase are performed. The subsequent phases can be performed by analogy. The steps S22 and S23 are alternately performed, that is, a cleaning phase is further performed after an etching phase, and the two phases alternate. Thereby, the deposits are timely removed from the ion source chamber, which reduces an impact of the deposits in the ion source chamber on the ionization of the etching gas. Moreover, it is prevented that a large amount of the deposits in the ion source chamber due to long-term etching brings difficulties in cleaning.

In another embodiment, performing the process of injecting the cleaning gas into the ion source chamber and ionizing the injected cleaning gas during the process of injecting the etching gas into the ion source chamber and ionizing the injected etching gas is implemented through as follows.

The process of injecting the cleaning gas into the ion source chamber and ionizing the injected cleaning gas is performed intermittently, while injecting the etching gas into the ion source chamber and ionizing the injected etching gas.

In one embodiment, the etching gas is continuously injected into the ion source chamber, and is ionized in the ion source chamber to generate the second plasma. During such process, the cleaning gas is injected intermittently into the ion source chamber. When being injected into the ion source chamber, the cleaning gas is ionized in the ion source chamber to generate the first plasma. At such time, the plasma in the ion source chamber is mixed plasma of the first plasma and the second plasma. A portion of the mixed plasma enters the etching chamber to etch the to-be-etched object, and another portion of the mixed plasma remains in the ion source chamber. The first plasma in the other portion of the mixed plasma remaining in the source chamber is capable of reacting with the deposits in the ion source chamber, so as to generate the gaseous compound for ejection. Thereby, the deposits are removed from the ion source chamber. When not injecting the cleaning gas into the ion source chamber, the etching gas is still injected into the ion source chamber, so that the second plasma generated by the etching gas in the ion source chamber continues entering the etching chamber to etch the to-be-etched object.

During injecting the etching gas into the ion source chamber, time for injecting the cleaning gas into the ion source chamber and an interval between two sequential phases of injecting the cleaning gas into the ion source chamber are not limited herein and may depend on an actual situation.

Reference is made to Figure 1 or 3. In an embodiment on a basis of any foregoing embodiment(s), the plasma processing device further comprises a baffle 30 disposed between the ion source chamber 10 and the etching chamber 20, and the method further comprises following steps.

The baffle 30 is disposed in a first state when the etching gas is injected into and ionized in the ion source chamber 10. The first state of the baffle 30 enables an inner space of the ion source chamber 10 and an inners space of the etching chamber 20 to connect with each other.

The baffle 30 is disposed in a second state when the etching gas is stopped from being injected into the ion source chamber 10 or when the etching is completed. The second state of the baffle 30 disconnects the inner space of the ion source chamber 10 and the inner space of the etching chamber 20.

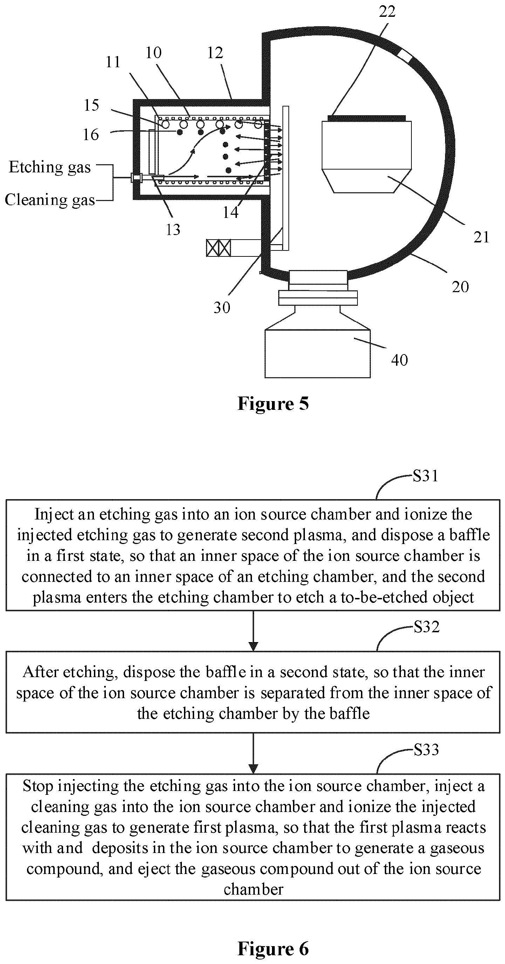

The baffle 30 may be retractable along a vertical or horizontal direction, or may be foldable. In one embodiment, it is taken as an example that the baffle 30 is retractable along the vertical direction. When the baffle 30 is disposed in the first state, the baffle 30 retracts vertically downward, as shown 30 in Figure 1 or Figure 3, so that the inner space of the ion source chamber 10 and the inner space of the etching chamber 20 are connected. When the baffle 30 is disposed in the second state, the baffle 30 extends vertically upward, as shown in Figure 5, so that the inner space of the ion source chamber 10 and the inner space of the etching chamber 20 are disconnected by the baffle 30. A specific form of the baffle 30 is not limited herein as long as the baffle 30 is capable to enable the ion source chamber 10 and the etching chamber 20 to switch between connection and disconnection in inner space.

The process of injecting the etching gas into the ion source chamber and ionizing the injected etching gas and the process of injecting the cleaning gas into the ion source chamber and ionizing the injected cleaning gas may be performed in coordination a status of the baffle. Hereinafter the foregoing coordination is illustrated in several embodiments.

In one embodiment, the cleaning gas is injected into and ionized in the ion source chamber after etching the to-be-etched object, that is, after the etching gas is injected into and ionized in the ion source chamber. Reference is made to Figure 6, where the method comprises following steps S31 to S33.

In step S31, the etching gas is injected into and ionized in the ion source chamber to generate the second plasma, and the baffle is disposed in the first state, as shown in Figure 1 or Figure 3. Thereby, the inner space of the ion source chamber is connected to the inner space of the etching chamber, and the second plasma enters the etching chamber to etch the to-be-etched object. That is, the etching is performed.

In step S32, after the etching, the baffle is disposed in the second state, as shown in Figure 5. Thereby, the inner space of the ion source chamber and the inner space of the etching chamber are separated by the baffle, so that an ion beam emitted from the ion source chamber is blocked, and the to-be-etched object is protected from over-etching.

In step S33, the etching gas is stopped from being injected into the ion source chamber, and instead the cleaning gas is injected into and ionized in the ion source chamber to generate the first plasma. Thereby, the first plasma reacts with and the deposits in the ion source chamber to generate the gaseous compound, and the gaseous compound is ejected from the ion source chamber. That is, the cleaning is performed.

Hence, the baffle is first disposed in the second state after the etching is completed, so as to separate the inner space of the ion source chamber and the inner space of the etching chamber, then the etching gas is stopped from being injected into the ion source chamber is stopped, and the cleaning gas is injected into and ionized in the ion source chamber. In one aspect, the to-be-etched object is protected from over-etching. In another aspect, when the cleaning gas is injected into and ionized the ion source chamber, a portion of the first plasma generated due to the ionization of the cleaning gas in the ion source chamber tends to be ejected out of the ion source chamber under acceleration, and the baffle in the second state can block and reflect such portion of the first plasma due to the separation between the inner space of the ion source chamber and the inner space of the etching chamber. Thus, as shown in Figure 5, the portion of the first plasma 16 has to return the ion source chamber 10, and react with the deposits 15 in the ion source chamber 10 along with another portion of the first plasma 16 that remains in the ion source chamber 10. Thereby, the gas compound is generated, and then ejected out of the ion source chamber 10. The deposits 15 are removed from the ion source chamber 10.

Thereby, a manner of cleaning in coordination with a status change of the baffle enables the first plasma to react fully with the deposits in the ion source chamber to generate the gaseous compound for ejection. Hence, an effect of cleaning the inner wall of the ion source chamber is improved.

In other embodiments, the process of injecting the cleaning gas into the ion source chamber and ionizing the injected cleaning gas may alternatively be performed during etching the to-be-etched object, i.e., during the process of injecting the etching gas into the ion source chamber and ionizing the etching gas in the ion source chamber. Correspondingly, the status change of the baffle is different in these embodiments, which is illustrated as follows.

In one embodiment, the process of injecting the cleaning gas into the ion source chamber and ionizing the injected cleaning gas is performed simultaneously with the process of injecting the etching gas into the ion source chamber and ionizing the etching gas in the ion source chamber, or the process of injecting the cleaning gas into the ion source chamber and ionizing the injected cleaning gas is performed intermittently, while injecting the etching gas into the ion source chamber and ionizing the etching gas in the ion source chamber. In such case, since the etching gas is continuously injected into the ion source chamber, the baffle is disposed in the first state, e.g., as shown in Figure 1 or Figure 3, when the etching gas is injected into and ionized in the ion source chamber. Thereby, the inner space of the ion source chamber and the inner space of the etching chamber are connected to facilitate the second plasma generated due to the ionization of the etching gas in the ion source chamber entering the etching chamber to etch the to-be-etched object. After the etching is completed, the baffle is disposed in the second state, e.g., as shown in Figure 5, so that the inner space of the ion source chamber and the inner space of the etching chamber are disconnected by the baffle. Thereby, the ion beam emitted from the ion source chamber is blocked, which protects the to-be-etched object from over-etching.

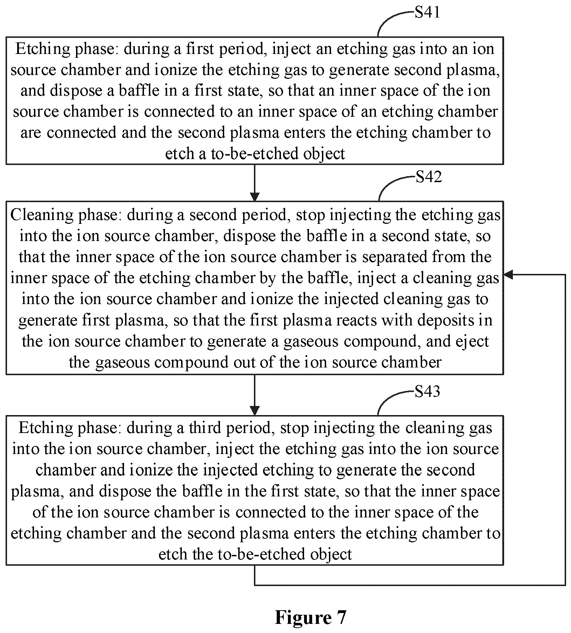

In another embodiment, the process of injecting the cleaning gas into the ion source chamber and ionizing the injected cleaning gas and the process of injecting the etching gas into the ion source chamber and ionizing the etching gas in the ion source chamber are performed alternatively. Correspondingly, reference is made to Figure 7, where the method comprises following steps S41 to S43.

In step S41, during the first period, the etching gas is injected into and ionized in the ion source chamber to generate the second plasma, and the baffle is disposed in the first state, e.g., as shown in Figure 1 or Figure 3. Thereby, the inner space of the ion source chamber and the inner space of the etching chamber are connected, so that the second plasma enters the etching chamber to etch the to-be-etched object. That is, the etching phase is performed, and is called the first etching phase.

In step S42, during the second period, the etching gas is stopped from being injected into the ion source chamber, and the baffle is disposed in the second state, e.g., as shown in Figure 5. Thereby, the inner space of the ion source chamber and the inner space of the etching chamber are separated by the baffle. Instead, the cleaning gas is injected into and ionized in the ion source chamber to generate the first plasma, so that the first plasma reacts with the deposits in the ion source chamber to generate the gaseous compound for ejection. That is, the cleaning phase is performed, and is called the first cleaning phase.

In step S43, during the third period, the cleaning gas is stopped from being injected into the ion source chamber, instead the etching gas is injected into and ionized in the ion source chamber to generate the second plasma, and the baffle is disposed in the first state, e.g., as shown in Figure 1 or Figure 3. Thereby, the inner space of the ion source chamber and the inner space of the etching chamber are connected, so that the second plasma enters the etching chamber to etch the to-be-etched object. That is, another etching phase is performed, and is called the second etching phase.

After the second etching process cycle is completed, the process returns to the step S42 and then the step S43, and hence a second cleaning phase and a third etching phase are performed. The subsequent phases can be performed by analogy. The steps S42 and S43 are alternately performed, that is, a cleaning phase is further performed after an etching phase, and the two phases alternate.

During the cleaning phase in the step S42, a portion of the first plasma generated due to the ionization of the cleaning gas in the ion source chamber tends to be ejected out of the ion source chamber under acceleration, and the baffle in the second state can block and reflect the first plasma bombarding the baffle due to the separation between the inner space of the ion source chamber and the inner space of the etching chamber. Thus, the portion of the first plasma 16 has to return and react with the deposits 15 in the ion source chamber 10 along with another portion of the first plasma 16 that remains in the ion source chamber 10. Thereby, the gas compound is generated and ejected out of the ion source chamber 10.

Thereby, a manner of cleaning in coordination with a status change of the baffle enables the first plasma to react fully with the deposits in the ion source chamber to generate the gaseous compound for ejection. Hence, an effect of cleaning the inner wall of the ion source chamber is improved.

In an embodiment on a basis of any foregoing embodiment(s), disposing the baffle in the first state, when the etching gas is injected into and ionized in the ion source chamber, to enable the inner space of the ion source chamber and the inner space of the etching chamber to connect comprises a following step.

In response to the etching gas being injected into and ionized in the ion source chamber and the ion beam emitted from the ion source chamber meeting a preset condition, the baffle is disposed in the first state to enable the inner space of the ion source chamber and the inner space of the etching chamber to connect.

Hereinafter it is taken as an example that the process of injecting the etching gas into the ion source chamber and ionizing the injected etching gas and the process of injecting the cleaning gas into the ion source chamber and ionizing the injected cleaning gas.

Reference is made to Figure 5. Before the processing starts, the baffle 30 is disposed in the second state, so that the inner space of the ion source chamber 10 and the inner space of the etching chamber 20 are separated by the baffle 30. When the etching gas and the cleaning gas are simultaneously injected into the ion source chamber 10, the baffle 30 is still disposed in the second state. At such time, the etching gas in the ion source chamber 10 is ionized to generate the second plasma, the cleaning gas in the ion source chamber 10 is ionized to generate the first plasma 16, and a mixture of the first plasma and the second plasma are accelerated by the accelerating grid 14 in the ion source chamber 10 to form the ion beam emitted from the ion source chamber 10. The ion beam bombards the baffle 30, is blocked and reflected by the baffle 30, and hence returns to the ion source chamber 10. In a case that the ion beam emitted by the ion source chamber 10 meets the preset condition, the baffle 30 is disposed in the first state, e.g., shown in Figure 3, so that the inner space of the ion source chamber 10 is connected to the inner space of the etching chamber 20. In such case, the ion beam emitted from the ion source chamber 10 can etch the to-be-etched object. During the above process, the first plasma and the second plasma remaining in the ion source chamber 10, especially the first plasma 16 remaining in the ion source chamber 10, can react with the deposits in the ion source chamber 10. Thereby, the gaseous compound capable to be ejected from the ion source chamber 10 is formed.

In one embodiment, the preset condition refers to a density, speed, or the like of the ion beam emitted by the ion source chamber 10 satisfying a requirement of the etching.

Reference is further made to Figure 1, 3, or 5. In an embodiment on a basis of any foregoing embodiment(s), the plasma processing device further comprises a vacuum pump 40 disposed at a bottom of the etching chamber 10. In a manner of cleaning, the cleaning gas is injected into and ionized in the ion source chamber to generate the first plasma, thereby the first plasma reacts with the deposits in the ion source chamber to generate the gaseous compound, and the gaseous compound may be removed using the vacuum pump.

Reference is further made to Figure 1, 3, or 5. In an embodiment on a basis of any foregoing embodiment(s), the plasma processing device further comprises a stage 21 disposed in the etching chamber 20. The method also comprises following steps.

Before the etching starts, the stage 21 carrying the to-be-etched object 22 is rotated from an initial position (e.g., a position of the stage 21 in Figure 5) to a processing position (e.g., a position of the stage in Figure 3). Thereby, it is facilitated that the second plasma generated due to the ionization of the etching gas in the ion source chamber etches the to-be-etched object after entering the etching chamber.

After the etching is completed, the stage 21 carrying the to-be-etched object 22 is returned to the initial position, so as to protect the to-be-etched object from over-etching.

In summary, the method for processing using plasma according to embodiments of the present disclosure is applicable to the plasma processing device comprising the ion source chamber, where the deposits are located in the ion source chamber. The method comprises: injecting the cleaning gas into the ion source chamber and ionizing the cleaning gas in the ion source chamber to generate the first plasma; and ejecting the gaseous compound, generated through reaction between the first plasma and the deposits in the ion source chamber, from the ion source chamber. Thereby, the deposits are removed from the ion source chamber. The method is more efficient, less time-consuming, and less costly than opening the ion source chamber manually for cleaning in conventional technology, and a yield can be increased.

The embodiments of the present disclosure are described through a combination of a progressive manner and a parallel manner, and each embodiment places emphasis on the difference from other embodiments. Therefore, one embodiment can refer to other embodiments for the same or similar parts.

According to the description of the disclosed embodiments, features in all embodiments may be replaced or combined with each other, and those skilled in the art can implement or use the present disclosure. Various modifications made to these embodiments may be obvious to those skilled in the art, and the general principle defined herein may be implemented in other embodiments without departing from the spirit or scope of the present disclosure. Therefore, the present disclosure is not limited to the embodiments described herein but conforms to a widest scope in accordance with principles and novel features disclosed in the present disclosure.

## Claims

1. A method for processing using plasma, applicable to a plasma processing device which comprises an ion source chamber, wherein deposits are located in the ion source chamber, and the method comprises:
injecting a cleaning gas into the ion source chamber and ionizing the cleaning gas in the ion source chamber to generate first plasma; and
ejecting a gaseous compound, which is generated through reaction between the first plasma and the deposits in the ion source chamber, from the ion source chamber.

2. The method according to claim 1, wherein the plasma processing device further comprises an etching chamber, and the method further comprises:
injecting an etching gas into the ion source chamber and ionizing the etching gas in the ion source chamber to generate second plasma, wherein the generated second plasma enters the etching chamber to etch a to-be-etched object.

3. The method according to claim 2, wherein a process of injecting the cleaning gas into the ion source chamber and ionizing the cleaning gas in the ion source chamber is performed after a process of injecting the etching gas into the ion source chamber and ionizing the etching gas in the ion source chamber.

4. The method according to claim 2, wherein a process of injecting the cleaning gas into the ion source chamber and ionizing the cleaning gas in the ion source chamber is performed during a process of injecting the etching gas into the ion source chamber and ionizing the etching gas in the ion source chamber.

5. The method according to claim 4, wherein the process of injecting the cleaning gas into the ion source chamber and ionizing the cleaning gas in the ion source chamber is performed simultaneously with the process of injecting the etching gas into the ion source chamber and ionizing the etching gas in the ion source chamber.

6. The method according to claim 4, wherein the process of injecting the cleaning gas into the ion source chamber and ionizing the cleaning gas in the ion source chamber and the process of injecting the etching gas into the ion source chamber and ionizing the etching gas are performed alternately.

7. The method according to claim 4, wherein the process of injecting the cleaning gas into the ion source chamber and ionizing the cleaning gas in the ion source chamber is performed intermittently, while injecting the etching gas into the ion source chamber and ionizing the etching gas in the ion source chamber.

8. The method according to any one of claims 2 to 7, wherein the plasma processing device further comprises a baffle disposed between the ion source chamber and the etching chamber, and the method further comprises:
disposing the baffle in a first state, when injecting the etching gas into the ion source chamber and ionizing the etching gas in the ion source chamber, wherein the first state of the baffle enables an inner space of the ion source chamber and an inner space of the etching chamber to connect; and
disposing the baffle in a second state when stopping injecting the etching gas into the ion source chamber or when completing etching the to-be-etched object, where the second state of the baffle disconnects the inner space of the ion source chamber and the inner space of the etching chamber are blocked by the baffle.

9. The method according to claim 2, wherein the etching gas is a fluorine-based gas.

10. The method according to claim 9, wherein the cleaning gas is oxygen.
